# EUROPEAN PATENT APPLICATION

(11) **EP 4 528 943 A2**
(43) Date of publication of application: **26.03.2025**
(21) Application number: 24187174.8
(22) Date of filing: 08.07.2024
(51) Int. Cl.: H01S 5/042

(54) **CONSTANT CURRENT EMISSION CIRCUIT AND LIDAR**

(30) Priority: 04.09.2023 CN 202311138862
(71) Applicant: Suteng Innovation Technology Co., Ltd., Shenzhen City Guangdong 518000 (CN)
(72) Inventor: Liang, Ying, Shenzhen 518000 (CN)
(74) Representative: RGTH

(57) **Abstract**

A constant current emission circuit and a LiDAR are provided. The constant current emission circuit includes a constant current power adjustable module and a constant voltage emission module. The constant current power adjustable module includes an energy storage element. The input end of the constant current power adjustable module is used to connect to the emission power supply that outputs the power supply voltage to charge the energy storage element. The constant current power adjustable module provides a constant current to the energy storage element and adjusts the energy stored in the energy storage element. The constant voltage emission module includes a laser connected to the energy storage element. This constant current emission circuit provide a constant current to the energy storage element, avoiding the problem of false laser emissions and ensuring the reliability and accuracy of the emitted laser beams.

## Description

### TECHNICAL FIELD

This application relates to the field of LiDAR technology, particularly to a constant current emission circuit and LiDAR.

### BACKGROUND

LiDAR is a key part of achieving autonomous driving, with advantages such as high measurement detection requirements, fine time and space resolution, and long measurement distances. With the development of automotive autonomous driving technology, various types of LiDAR have emerged to meet the needs of different scenarios.

A switch control module is set between the constant voltage emission power supply and the laser to adjust the drive voltage provided to the laser by the constant voltage emission power supply through the switch control module. However, when charging with a constant voltage emission power supply, the charging current can be infinitely large, potentially exceeding the current threshold required for laser emission, causing issues with false laser emissions.

### SUMMARY

Embodiments of this application provides a constant current emission circuit and LiDAR. The constant current emission circuit provide a constant current to the energy storage element, avoiding false laser emissions, ensuring the reliability and accuracy of the emitted laser beams.

In a first aspect, embodiments of this application provides a constant current emission circuit, including a constant current power adjustable module and a constant voltage emission module. The constant current power adjustable module includes an energy storage element. An input end of the constant current power adjustable module is connected to the emission power supply, for receiving output the power supply voltage to charge the energy storage element. The constant current power adjustable module provides a constant current to the energy storage element and adjusts the energy stored in the energy storage element. The constant voltage emission module includes a laser connected to the energy storage element. The laser emits a laser beam when the energy storage element discharges energy, different energies stored in the energy storage element correspond to different laser emission powers.

The constant current power adjustable module is equipped with an energy storage element, a first control circuit, and a second control circuit. By controlling the conduction state and conduction time of the first and second control circuits, the constant current emission circuit emit laser beams of different powers based on the power supply voltage. Ensures that the charging current flowing into the energy storage element is a constant current, thereby ensuring the stability of the current entering the energy storage element, avoiding the issues of high current impact damaging the laser connected in parallel with the energy storage element and false laser emissions. And ensure the reliability of the laser emission from the constant current emission circuit. The second control circuit has a fast switch response speed, ensure the overall reliability of the constant current emission circuit, make it suitable for different LiDARs and detection scenarios. The constant current emission circuit result in a simple overall structure and low energy loss due to the absence of a boosting process.

In an embodiment, the constant current power adjustable module includes: a first control circuit and a second control circuit. One end of the first control circuit is connected to the emission power supply, and the other end is connected to the energy storage element. One end of the second control circuit is connected to a second end of the energy storage element, and the other end is grounded. When charging the energy storage element, both the first and second control circuits are turned on, and a turn-on time of the first control circuit and the second control circuit is controllable, to charge the energy storage element through the emission power supply and control the energy stored in the energy storage element. A current flowing through the first control circuit and flowing into the energy storage element is a constant current. When discharging the energy storage element, at least the first control circuit is turned off.

The first control circuit ensures that the current flowing through the first control circuit and into the energy storage element is a constant current. The constant current power adjustable module ensures that the charging current in the charging stage is a constant current, avoiding damage to the energy storage element, and allows adjustment of the energy stored in the energy storage element, ensuring the reliability and accuracy of the emitted laser beams, thereby ensuring the detection reliability and accuracy of the LiDAR using the constant current emission circuit.

In an embodiment, the first control circuit includes: a first high-side switch, where a drain of the first high-side switch is connected to the emission power supply, a source of the first high-side switch is connected to the first end of the energy storage element, and a controlled end of the first high-side switch is configured to receive a power supply control signal.

The voltage difference between the energy storage element and the emission power supply is large, causing the first high-side switch to operate in the saturation region. The current flowing through the first high-side switch and into the energy storage element is a constant current, ensuring the reliability of the laser during the charging stage.

In an embodiment, the first control circuit includes: a first switch, which is connected in series between the emission power supply and the first end of the energy storage element.

The conduction state and conduction time of the first switch can be controlled to precisely control the charging state and the energy stored in the energy storage element, ensuring the reliability of the emitted laser.

In an embodiment, the second control circuit includes: a first low-side switch and a second low-side switch. A drain of the first low-side switch is connected to the second end of the energy storage element, and a controlled end of the first low-side switch is configured to receive an energy storage control signal. A drain of the second low-side switch is grounded, a source of the second low-side switch is connected to a source of the first low-side switch, and a controlled end of the second low-side switch is configured to receive the energy storage control signal.

The first and second low-side switches can achieve fast conduction and cut-off control of the ground conduction loop of the energy storage element during the discharging stage, enabling precise control of the charging energy of the energy storage element.

In an embodiment, the second control circuit includes: a diode, where an anode of the diode is connected to the second end of the energy storage element, and a cathode of the diode is grounded.

The diode stabilizes and protects the constant current power adjustable module. During the charging stage, the diode conducts to charge the energy storage element. When the diode is off, the charging loop is disconnected to precisely control the charging energy of the energy storage element. During the discharging stage, the energy released by the energy storage element flows into the anode of the laser and exits from the cathode of the laser. Due to the unidirectional conductivity of the diode, the current exiting from the cathode of the laser flows into the second end of the energy storage element, forming a discharging loop, ensuring the reliability of the discharging stage.

In an embodiment, the laser includes: a laser diode, where an anode of the laser diode is grounded, and a cathode of the laser diode is connected to an anode of the first diode and the second end of the energy storage element.

In an embodiment, the second control circuit includes: a second switch, which is connected in series between the second end of the energy storage element and a grounding end.

In an embodiment, the constant voltage emission module includes: an emission control switch, where a source of the emission control switch is connected to the anode of the laser, a drain of the emission control switch is connected to the first end of the energy storage element, and a controlled end of the emission control switch is connected to receive an emission control signal. A cathode of the laser is connected to the second end of the energy storage element. When charging the energy storage element, the emission control switch is turned off. When discharging the energy storage element, the emission control switch is turned on.

In the second aspect, embodiments of this application provides a LiDAR, including: the constant current emission circuit in the embodiments of first aspect, a controller, and a laser receiving circuit. The controller is connected to the constant current power adjustable module and the constant voltage emission module. The laser receiving circuit is connected to the controller and is used to receive the echo light formed by the laser emitted by the constant current emission circuit and reflected by the target object.

In an embodiment, the LiDAR includes: a laser array composed of M*N lasers, where M and N are the number of rows and columns of lasers in the laser array, respectively. M and N are positive integers, and at least one of M and N is greater than or equal to 2.

The LiDAR can be a combination of one laser corresponding to one constant current power adjustable module, a combination of a laser array composed of multiple lasers corresponding to one constant current power adjustable module, or a combination of a laser array composed of multiple lasers corresponding to multiple constant current power adjustable modules. In an embodiment, since the constant current power adjustable module does not include inductors or other charging components, there is no inductor discrepancy issue, ensuring the high uniformity of the emitted laser beams from the overall system. In an embodiment, the LiDAR includes multiple constant current power adjustable modules and lasers, the overall heat generated by the circuit is low, and circuit loss is minimized.

Based on the constant voltage emission circuit and LiDAR, the constant voltage emission circuit can emit laser beams of different powers based on the power supply voltage. Ensures that the charging current flowing into the energy storage element during the charging stage is a constant current, ensuring the overall reliability of the constant voltage emission circuit, thereby ensuring the detection reliability of the LiDAR using the constant current emission circuit.

### BRIEF DESCRIPTION OF DRAWINGS

In order to clearly illustrate the technical solutions of this application's embodiments, the following briefly introduces the drawings needed for the description of the embodiments.
FIG. 1 is a schematic diagram of a low-voltage emission circuit;
FIG. 2 is a schematic diagram of another constant voltage emission circuit;
FIG. 3 is a schematic diagram of the frame structure of a LiDAR provided by an embodiment;
FIG. 4 is a schematic diagram of another frame structure of a LiDAR provided by an embodiment;
FIG. 5 is a schematic diagram of the frame structure of a constant current emission circuit provided by an embodiment;
FIG. 6 is a schematic diagram of another frame structure of a constant current emission circuit provided by an embodiment;
FIG. 7 is a schematic diagram of the circuit structure of a constant current emission circuit provided by an embodiment;
FIG. 8 is a schematic diagram of another circuit structure of a constant current emission circuit provided by an embodiment;
FIG. 9 is a schematic diagram of yet another circuit structure of a constant current emission circuit provided by an embodiment;
FIG. 10 is a schematic diagram of another circuit structure of a constant current emission circuit provided by an embodiment;
FIG. 11 is a schematic diagram of another circuit structure of a constant current emission circuit provided by an embodiment;
FIG. 12 is a schematic diagram of another circuit structure of a constant current emission circuit provided by an embodiment;
FIG. 13 is a schematic diagram of another circuit structure of a constant current emission circuit provided by an embodiment.

Drawing reference numbers:
1- LiDAR; 11- constant current emission circuit; 111- constant current power adjustable module; 1111- energy storage element; 1112- first control circuit; 1113- second control circuit; 112-constant voltage emission module; 1121- laser; 12- controller; 13- laser receiving circuit; V1- low voltage emission power supply; V2- constant voltage emission power supply; V3-emission power supply; L- inductor; Q1- first switch element; Q2- second switch element; Q3-first high-side switch; Q4- third low-side switch; Q5- second high-side switch; Q6- first low-side switch; Q7- second low-side switch; Q8- emission control switch; D1- rectifying diode; D2- diode; D3- laser diode; C1- capacitor; C2- energy storage capacitor.

### DETAILED DESCRIPTION

To make the objectives, technical solutions, and advantages of the embodiments of this application clearer, the technical solutions in the embodiments of this application will be described clearly below with reference to the accompanying drawings in the embodiments of this application.

To make the objectives, technical solutions, and advantages of this application clearer, the following provides a detailed description of the embodiments of this application with reference to the accompanying drawings.

When the following description refers to the accompanying drawings, unless otherwise indicated, the same numbers in different drawings represent the same or similar elements. The embodiments described below are merely exemplary and do not represent all possible embodiments consistent with this application.

The terms "first," "second," etc., are only used for descriptive purposes and cannot be interpreted as indicating or implying relative importance. The specific meanings of these terms in this application can be understood based on the specific context. Unless otherwise specified, "multiple" refers to two or more. "And/or" describes the relationship between associated objects, indicating that three types of relationships can exist: A and/or B can mean: A alone, A and B simultaneously, or B alone. The character "/" generally indicates that the preceding and following associated objects have an "or" relationship.

The term "and/or" includes any and all combinations of one or more of the associated listed items.

LiDAR technology is becoming increasingly mature and is widely used in various fields such as ranging, mapping, traffic management, and atmospheric monitoring. LiDAR comprises a laser emitter and a laser detector. The laser emitter emits laser beams to target objects within the detection area, while the laser detector receives echo light reflected from the target objects. LiDAR can determine the distance and speed of target objects based on the echo light, thereby completing the detection process. In order to enable a laser emitter to be stimulated to emit laser light, it is usually necessary to provide the laser emitter with a driving current of a required intensity to ensure that it can be stimulated to emit laser light based on the driving current.

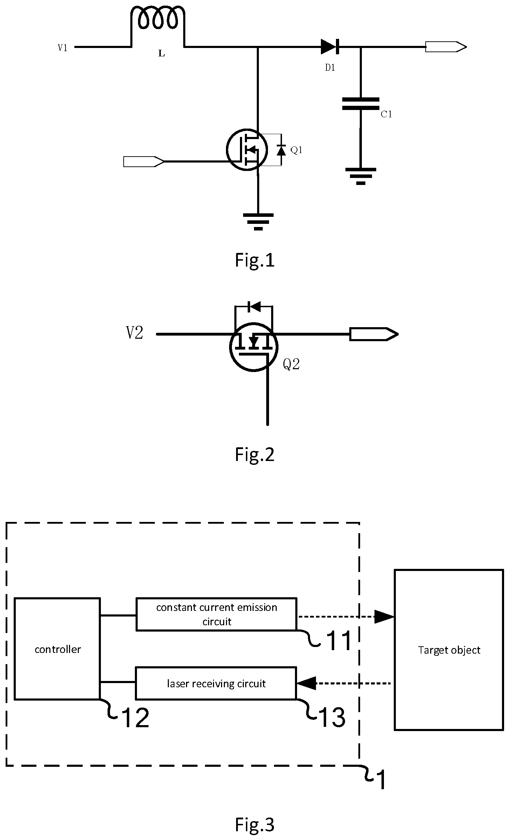

A low-voltage emission power supply or a constant voltage emission power supply is usually used to provide the driving voltage for the laser. In an embodiment, see FIG. 1, which illustrates a drive circuit and energy control drive adjustment circuit for providing drive current to the laser. This drive circuit comprise an inductor (as shown in FIG. 1, L), a first switch element (as shown in FIG. 1, Q1), a rectifying diode (as shown in FIG. 1, D1), and a capacitor (as shown in FIG. 1, C1). One end of inductor L is connected to the low-voltage emission power supply (as shown in FIG. 1, V1), and the other end of inductor L is connected to the drain of the first switch element Q1. The source of the first switch element Q1 is connected to one end of the rectifying diode D1, and the controlled end of the first switch element Q1 is connected to receive an emission control signal. The other end of the rectifying diode D1 is connected to the first electrode of capacitor C1 and the input end of the laser emitter. The second electrode of capacitor C1 is grounded. When the first switch element Q1 is turned on, the low-voltage emission power supply V1 provides current to charge inductor L. When the first switch element Q1 is turned off, the current in inductor L flows through the rectifying diode D1 to charge capacitor C1. Once capacitor C1 is charged, it discharges to the input end of the laser transmitter. The discharge of capacitor C1 provides the drive current for the laser transmitter, allowing the laser emitter to be stimulated by the drive current to emit laser beams. This drive adjustment circuit is a boost circuit. In the process of converting low voltage to high voltage, due to the presence of inductor L, there is some loss during the actual boost process, leading to some energy loss in the laser transmitter. The LiDAR may be connected to other peripheral circuits. Due to the inductor L, large cables are required for high-current transmission, resulting in cable loss issues. Furthermore, the area occupied by inductor Land the first switch element Q1 is large, generating significant heat during use, which increases the area and heat dissipation cost, making it unsuitable for integrated.

When multiple drive adjustment circuits are set up in the LiDAR to drive multiple laser groups, the LiDAR volume becomes excessively large. Due to differences between inductors L, the power of the emitted laser beams of multiple lasers may be affected, leading to poor uniformity of the emitted laser beams from the LiDAR and suboptimal detection performance.

In an embodiment, see FIG. 2, which illustrates a drive circuit that provides the driving voltage for the laser using a constant voltage emission power supply. This drive circuit comprises a second switch element (as shown in FIG. 2, Q2). A drain of the second switch element Q2 is connected to the constant voltage emission power supply (as shown in FIG. 2, V2), a source of the second switch element Q2 is connected to an input end of the laser emitter, and a controlled end of the second switch element Q2 is connected to receive an emission control signal. The emission control signal controls the on/off state and conduction time of the second switch element Q2, thereby controlling the laser's emission state and the power of the emitted laser. However, when charging with the constant voltage emission power supply V2, the charging current is infinitely large, which may lead to the charging current exceeding the threshold current required for laser emission, resulting in false laser emission. To avoid this issue, current-limiting resistors or other components are added to limit the charging current, which increases power consumption and reduces charging efficiency, while increasing the drive circuit's size. Furthermore, in LiDARs that use a constant voltage emission power supply V2, high voltage needs to be discharged and low voltage needs to be charged and converted. There are many parasitic capacitors and inductors in the laser transmitter, which slow down the process of high-voltage discharge and low-voltage charging, affecting the laser emission frequency of the LiDAR.

Embodiments of this application provides a constant current emission circuit and LiDAR. The constant current emission circuit provide a constant current to the energy storage element, avoiding the issue of excessive charging current causing false laser emission and ensuring the reliability and accuracy of the emitted laser beams.

In an embodiment, refer to FIG. 3, which shows an embodiment of a LiDAR 1. LiDAR 1 can include a constant current emission circuit 11, a controller 12, and a laser receiving circuit 13. Controller 12 is connected to the constant current emission circuit 11 and the laser receiving circuit 13. Controller 12 is used to control the emission of the constant current emission circuit 11 and to control the laser receiving circuit 13 to receive the echo light formed by the laser emitted by the constant current emission circuit 11 and reflected by the target object, thereby determining the distance and speed of the target object and completing the detection of the target object.

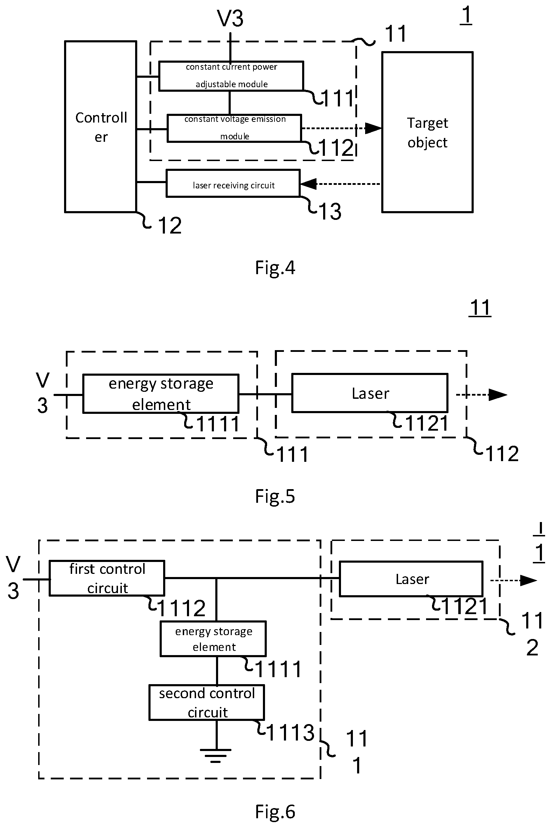

In an embodiment, refer to FIG. 4. Constant current emission circuit 11 include a constant current power adjustable module 111 and a constant voltage emission module 112. An input end of the constant current power adjustable module 111 is connected to the emission power supply (as shown in FIG. 4, V3) to receive the power supply voltage provided by the emission power supply V3. The constant current power adjustable module 111 can adjust the power of the laser emitted by the constant voltage emission module 112 based on the power supply voltage. The constant current emission circuit 11 can emit laser beams with different powers based on the power supply voltage, enabling the LiDAR 1 to detect target objects at different distances within a wider range and broadening the detection range of the constant current emission circuit 11.

In an embodiment, refer to FIG. 5. The constant current power adjustable module 111 include an energy storage element 1111. The constant current power adjustable module 111 is used to provide a constant current to the energy storage element 1111. The constant voltage emission module 112 include a laser 1121. The constant current power adjustable module 111 includes at least two stages: the charging stage and the discharging stage of the energy storage element 1111. The charging stage of the energy storage element 1111 comprises charging 1111 with the power supply voltage, and the discharging stage of the energy storage element 1111 comprises releasing the stored energy in the energy storage element 1111 to drive the laser 1121 to emit laser beams, thereby completing the stimulated emission process. In an embodiment, to avoid the problem of false laser emission caused by excessive charging current during the charging process, the current flowing into the energy storage element 1111 during charging is a constant current, thereby stabilizing the charging current and avoiding the problem of false laser emission caused by excessive charging current, ensuring the reliability and accuracy of the laser beams emitted by the laser 1121. The constant current power adjustable module 111 adjust the energy stored in the energy storage element 1111. By adjusting the energy stored in the energy storage element 1111, the laser 1121 emit laser beams with different powers, thus enabling the constant current emission circuit 11 to emit laser beams with different powers based on a constant high voltage, thereby achieving the detection of target objects at different distances within a wider range.

The power supply voltage provided by the emission power supply V3 connected to the constant current power adjustable module 111 can be a constant voltage or a non-constant voltage.

Since the energy storage element 1111 generates strong reverse current fluctuations at both ends during the charging process, and the energy storage element 1111 is connected in parallel with the laser 1121 in the constant voltage emission module 112, there may be reverse current flowing to the laser 1121, which may damage the laser 1121 due to the impact of high current. To ensure that the charging current is a constant current during the charging stage and to precisely control the energy stored in the energy storage element 1111 to ensure the reliability of the laser emission by the laser 1121. In an embodiment, the constant current power adjustable module 111 includes: a first control circuit 1112 and a second control circuit 1113. One end of the first control circuit 1112 is connected to the emission power supply V3, and the other end of the first control circuit 1112 is connected to the energy storage element 1111. One end of the second control circuit 1113 is connected to the second end of the energy storage element 1111, and the other end of the second control circuit 1113 is grounded. By controlling the conduction state and conduction time of the first control circuit 1112 and the second control circuit 1113, the charging state of the emission power supply V3 to the energy storage element 1111 and the energy stored in the energy storage element 1111 can be controlled. Through the first control circuit 1112, the current flowing through the first control circuit 1112 and into the energy storage element 1111 can be a constant current. Thus, the constant current power adjustable module 111 provided by embodiments ensures that the charging current in the charging stage is a constant current, avoiding damage to the energy storage element and the problem of false laser emission, and enables the adjustment of the energy stored in the energy storage element 1111, ensuring the reliability and accuracy of the laser emitted by the laser 1121, thereby ensuring the detection reliability and accuracy of the LiDAR 1 that uses the constant current emission circuit 11.

In an embodiment, in the charging stage of the energy storage element 1111, both the first control circuit 1112 and the second control circuit 1113 are turned on. The current corresponding to the power supply voltage provided by the emission power supply V3 sequentially flows through the first control circuit 1112, the energy storage element 1111, and the second control circuit 1113 to the ground, forming a charging loop. At this time, the first control circuit 1112 ensures that the current flowing through the first control circuit 1112 and into the energy storage element 1111 is a constant current, ensuring the stability of the current entering the energy storage element 1111, thereby avoiding the problem of the laser 1121 being damaged due to high current impact in parallel with the energy storage element 1111. Furthermore, the first control circuit 1112 can prevent the charging current from being infinitely large, ensuring the reliability and accuracy of the laser 1121 emitted by the laser, thus avoiding the problem of false laser emission, ensuring the detection accuracy and reliability of the LiDAR 1.

Thus, the first control circuit 1112 ensure that the charging current in the charging stage is a constant current, ensuring the reliability of the laser 1121 emitted by the laser. Additional boost circuits (such as boost inductors) are not require to charge the energy storage element 1111. The structure is simple, resulting in low energy loss and reduced heat generation, saving heat dissipation costs. The constant current emission circuit 11 can emit laser beams at a higher frequency, allowing the LiDAR 1 to emit laser beams at high point frequencies.

In an embodiment, the constant current power adjustable module 111 adjust the charging state and the energy stored in the energy storage element 1111 by controlling the conduction state and conduction time of the first control circuit 1112 and the second control circuit 1113. When the power supply voltage is connected, the charging state of the energy storage element 1111 and the amount of energy stored in the energy storage element 1111 are adjusted. Since the other end of the second control circuit 1113 is grounded, the reference level is always 0V, ensuring a stable voltage difference in the second control circuit 1113, eliminating the need for a bootstrap capacitor charging process, and ensuring a fast response speed. When the second control circuit 1113 is turned off, the charging loop formed by the first control circuit 1112, the energy storage element 1111, and the second control circuit 1113 will be immediately cut off, enabling precise control of the charging state and the energy stored in the energy storage element 1111, ensuring the reliability of the emitted laser.

The conduction state and conduction time of the first control circuit 1112 and the second control circuit 1113 are controlled and set by the controller 12. During the discharging stage of the energy storage element 1111, the second control circuit 1113 is turned off, and the ground conduction loop of the energy storage element 1111 is quickly cut off, ensuring the precision of the energy storage element 1111's discharging process, thus ensuring the accuracy of the laser emitted by the constant voltage emission module 112.

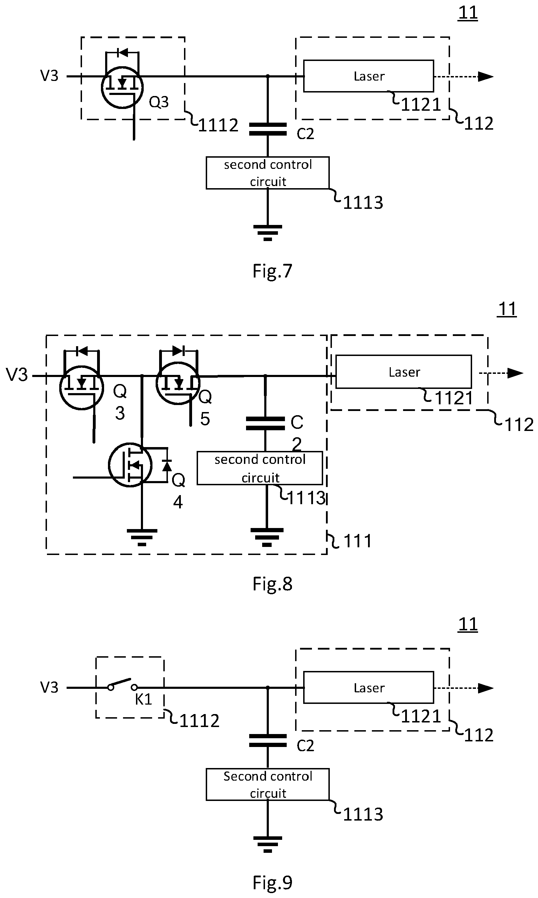

In an embodiment, refer to FIG. 7. The first control circuit 1112 is a first high-side switch (Q3). The energy storage element 1111 being an energy storage capacitor (C2). A drain of the first high-side switch Q3 is connected to the emission power supply V3, a source of the first high-side switch Q3 is connected to the first end of the energy storage capacitor C2, and a controlled end (the gate) of the first high-side switch Q3 is connected to receive a power supply control signal. The power supply control signal is provided by the controller 12 and adjust the conduction state and conduction time of the first high-side switch Q3 by adjusting the frequency of the power supply control signal. During the charging stage, the first high-side switch Q3 ensures that the charging current flowing to the energy storage capacitor C2 is a constant current. The first high-side switch Q3 based on whether the power supply voltage provided by the emission power supply V3 is constant or non-constant.

First case: The power supply voltage provided by the emission power supply V3 is a constant voltage.

Initially, the voltage of the energy storage capacitor C2 is 0V (volts) or low voltage. At this time, the voltage difference between the energy storage capacitor C2 and the emission power supply V3 is large. When the charging stage begins, due to the large voltage difference between the energy storage capacitor C2 and the emission power supply V3, the current through the first high-side switch Q3 rapidly rises from zero to saturation, ensuring that the current flowing through the first high-side switch Q3 and into the energy storage capacitor C2 is a constant current, ensuring the reliability of the laser 1121 during the charging stage. By adjusting the linear conduction time of the first high-side switch Q3 through the power supply control signal, the first high-side switch Q3 can precisely control the energy stored in the energy storage capacitor C2, thereby achieving linear control of the laser power emitted by the laser 1121. After the charging stage ends, the discharging stage begins. At this time, the energy storage capacitor C2 releases energy, causing the laser 1121 to emit laser beams with corresponding power. By adjusting the conduction state and conduction time of the first high-side switch Q1, the laser 1121 can emit laser beams with different powers, enabling the LiDAR 1 to detect target objects at different distances within a wider range, expanding the detection range of the constant current emission circuit 11.

The energy storage capacitor C2 is continuously charged during the charging stage, the voltage difference between the energy storage capacitor C2 and the emission power supply V3 gradually decreases. When the voltage difference is reduced to a certain value, the first high-side switch Q3 may enter the linear region, causing the current flowing through the first high-side switch Q3 and into the energy storage capacitor C2 to no longer be a constant current. To avoid this situation, the power supply voltage of the emission power supply V3 can be set higher than or equal to the target voltage of the energy storage capacitor C2. Initially, there will be a rapid rise in current to saturation (constant current), and as the target voltage is approached, the first high-side switch Q3 enters the linear region, causing the current to rapidly decrease, allowing the energy storage capacitor C2 to closely approach the target voltage. Here, sufficient time is reserved for charging, ensuring that each path can reach a voltage close to the target voltage. Thus, during the charging stage, before the voltage of the energy storage capacitor C2 reaches the target voltage, the voltage difference between the energy storage capacitor C2 and the emission power supply V3 is always greater than a certain value, keeping the first high-side switch Q3 in the saturation region, ensuring that the current flowing through the first high-side switch Q3 and into the energy storage capacitor C2 is a constant current, ensuring the reliability of the laser 1121 during the charging stage.

Second case: The power supply voltage provided by the emission power supply V3 is a non-constant voltage.

The voltage of the energy storage capacitor C2 is 0V (volts) or low voltage. The voltage difference between the energy storage capacitor C2 and the emission power supply V3 is large. When the charging stage begins, due to the large voltage difference between the energy storage capacitor C2 and the emission power supply V3, the first high-side switch Q3 is in the saturation region, ensuring that the current flowing through the first high-side switch Q3 and into the energy storage capacitor C2 is a constant current, ensuring the reliability of the laser 1121 during the charging stage. As the energy storage capacitor C2 is continuously charged during the charging stage, the voltage of the energy storage capacitor C2 increases. The power supply voltage provided by the emission power supply V3 can be increased, keeping the voltage difference between the energy storage capacitor C2 and the increased power supply voltage large, ensuring that the first high-side switch Q3 remains in the saturation region, ensuring that the current flowing through the first high-side switch Q3 and into the energy storage capacitor C2 is a constant current, avoiding the problem of false laser emission caused by the charging current exceeding the threshold current required for laser emission, ensuring the accuracy and reliability of the laser emitted by the constant voltage emission module 112, thereby ensuring the detection accuracy and reliability of the LiDAR 1.

In summary, embodiments of this application ensures that the charging current flowing through the first high-side switch Q1 into the energy storage capacitor C2 is a constant current by keeping the first high-side switch Q1 in the saturation region, ensuring the reliability of the laser 1121. There is no need to add additional components to limit the charging current, making the structure simple.

In an embodiment, refer to FIG. 8. The first control circuit 1112 include a third low-side switch (Q4). The source of the third low-side switch Q4 is grounded, the drain of the third low-side switch Q4 is connected to the source of the first high-side switch Q3, and the controlled end of the third low-side switch Q4 is connected to receive the power supply control signal. By adjusting the frequency of the power supply control signal, the conduction state and conduction time of the first high-side switch Q3 and the third low-side switch Q4 are adjusted, enabling precise control of the charging state and the energy stored in the energy storage capacitor C2, ensuring the reliability of the emitted laser.

After the discharging stage of the energy storage element 1111 ends, some energy remains in the energy storage capacitor C2. When the first low-side switch Q6 is in the on state, the remaining energy in the energy storage capacitor C2 may be released through the first low-side switch Q6, leading to energy backflow and certain energy loss, thereby requiring more energy for the next charging process, prolonging the charging stage time of the energy storage element 1111, and causing inconsistency with the preset charging time. This may lead to instability in the discharging stage of the energy storage element 1111, reducing the reliability of the emitted laser.

To avoid the problem of energy backflow in the energy storage capacitor C2 after the discharging stage of the energy storage element 1111, which reduce the reliability of the emitted laser. In an embodiment, refer to FIG. 8. The first control circuit 1112 include a second high-side switch (Q5). The source of the second high-side switch Q5 is connected to the source of the first high-side switch Q3, the drain of the second high-side switch Q5 is connected to the first end of the energy storage capacitor C2, and the controlled end of the second high-side switch Q5 is connected to receive the power supply control signal. Thus, the added second high-side switch Q5 can form a pair switch with the first high-side switch Q3, creating a bootstrap capacitor circuit, isolating the energy backflow problem of the energy storage capacitor C2, avoiding energy loss, and ensuring the regulation reliability of the constant current power adjustable module 111, ensuring the reliability of the emitted laser from the constant current emission circuit 11.

In an embodiment, refer to FIG. 9. The first control circuit 1112 can be the first switch (K1). The first switch K1 is connected in series between the emission power supply V3 and the first end of the energy storage capacitor C2. By controlling the conduction state and conduction time of the first switch K1, precise control of the charging state and the energy stored in the energy storage element 1111 can be achieved, ensuring the reliability of the emitted laser. At this time, a current-limiting element (such as a current-limiting resistor) can be added to limit the charging current.

The structure of the first control circuit 1112 can be set based on different LiDAR 1 configurations. In an embodiment, if the LiDAR 1 does not require ultra-low power consumption and aims for miniaturization, the first control circuit 1112 can be designed with only a single switch, simplifying the structure to meet the miniaturization requirements.

In an embodiment, the second control circuit 1113 can precisely control the charging energy of the energy storage capacitor C2 by achieving fast conduction and cut-off control of the ground conduction loop of the energy storage capacitor C2 during charging, ensuring the precision of the energy release from the energy storage capacitor C2 during the discharging stage, and thus ensuring the accuracy of the laser emitted by the constant voltage emission module 112. For example, during the charging stage, when the second control circuit 1113 is turned off, the charging loop is disconnected, allowing precise control of the charging energy of the energy storage capacitor C2. During the discharging stage, the second control circuit 1113 is turned on, allowing the energy released from the energy storage capacitor C2 to flow to the laser 1121, enabling narrow pulse laser emission. Here, it should be noted that the specific circuit form of the second control circuit 1113 can be diverse.

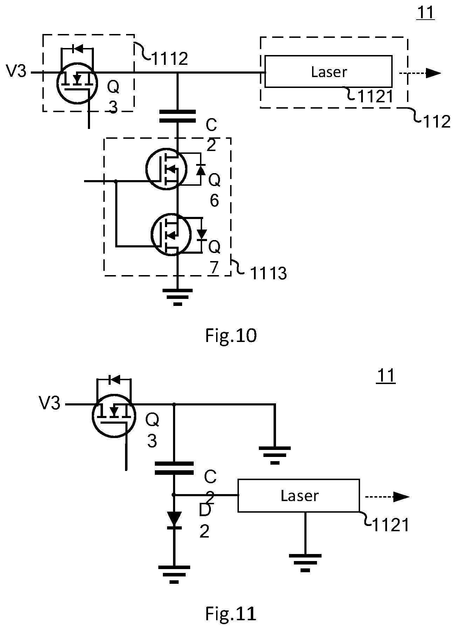

In an embodiment, refer to FIG. 10. The second control circuit 1113 include a first low-side switch (Q6) and a second low-side switch (Q7). The drain of the first low-side switch Q6 is connected to the second end of the energy storage capacitor C2, the controlled end of the first low-side switch Q6 is connected to receive the energy storage control signal, the drain of the second low-side switch Q7 is grounded, the source of the second low-side switch Q7 is connected to the source of the first low-side switch Q6, and the controlled end of the second low-side switch Q7 is connected to receive the energy storage control signal. The energy storage control signal is provided by the controller 12 and can adjust the frequency of the energy storage control signal according to different needs, thereby adjusting the conduction state and conduction time of the first low-side switch Q6 and the second low-side switch Q7. The first low-side switch Q6 and the second low-side switch Q7 can achieve fast conduction and cut-off control of the ground conduction loop of the energy storage capacitor C2 during the discharging stage, enabling precise control of the charging energy of the energy storage capacitor C2.

In an embodiment, refer to FIG. 11. The second control circuit 1113 include a diode (D2). The anode of the diode D2 is connected to the second end of the energy storage capacitor C2, and the cathode of the diode D2 is grounded to stabilize and protect the constant current power adjustable module 111, ensuring its stable operation. One end of the laser 1121 is grounded, and the other end of the laser 1121 is connected between the second end of the energy storage capacitor C2 and the anode of the diode D2. In an embodiment, the laser 1121 is a laser diode (Laser Diode, LD), the anode of the laser diode is grounded, and the cathode of the laser diode is connected between the second end of the energy storage capacitor C2 and the anode of the diode D2. During the charging stage, the diode D2 conducts, charging the energy storage capacitor C2. When the diode D2 turns off, the charging loop is disconnected, enabling precise control of the charging energy of the energy storage capacitor C2. During the discharging stage, the energy released from the energy storage capacitor C2 flows into the anode of the laser diode, exiting from the cathode of the laser diode. Since the diode D2 has unidirectional conductivity, the current exiting from the cathode of the laser diode flows into the second end of the energy storage capacitor C2, forming the discharging loop, ensuring the reliability of the discharging stage.

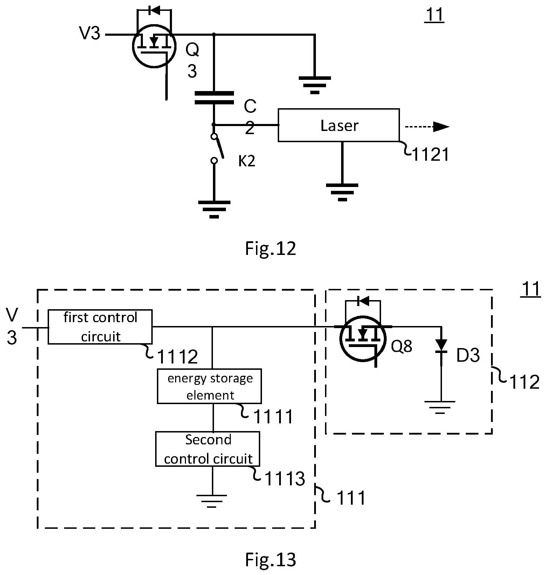

In an embodiment, as shown in FIG. 12, the second control circuit 1113 include a second switch (K2). The second switch K2 is connected in series between the second end of the energy storage capacitor C2 and the ground end. Through the second switch K2, the ground conduction loop of the energy storage capacitor C2 during the discharging stage can achieve fast conduction and cut-off control, enabling precise control of the charging energy of the energy storage capacitor C2.

In an embodiment, the second control circuit 1113 include other switch elements.

The constant current power adjustable module 111 is equipped with an energy storage element 1111, a first control circuit 1112, and a second control circuit 1113. By controlling the conduction state and conduction time of the first control circuit 1112 and the second control circuit 1113, the constant current emission circuit 11 can enable the laser 1121 to emit laser beams with different powers based on the power supply voltage. The first control circuit 1112 can ensure that the charging current flowing into the energy storage element 1111 is a constant current, thereby ensuring the stability of the current entering the energy storage element 1111, avoiding the problem of high current impact damaging the laser 1121 in parallel with the energy storage element 1111, and avoiding the problem of false laser emission, ensuring the reliability of the constant current emission circuit 11. Additionally, the second control circuit 1113 has a fast switch response speed, ensuring the overall reliability of the constant current emission circuit 11 for different LiDAR 1 and detection scenarios. The constant current emission circuit 11 making the overall structure simple, resulting in low energy loss.

In an embodiment, the LiDAR 1 can be configured in various combinations, such as one laser 1121 corresponding to one constant current power adjustable module 111, a laser array comprises multiple lasers 1121 corresponding to one constant current power adjustable module 111, or a laser array comprise multiple lasers 1121 corresponding to multiple constant current power adjustable modules 111. The laser array can comprise M*N lasers 1121, where M and N are the numbers of rows and columns of lasers 1121 in the array, respectively. M and N are positive integers, and at least one of M and N is greater than or equal to 2.

In an embodiment, the LiDAR 1 is a combination where multiple lasers 1121 form a laser array corresponding to one constant current power adjustable module 111, the LiDAR 1 include more lasers 1121, and the constant current power adjustable module 111 controls the emission state and the power of the emitted laser beams of the lasers 1121, ensuring high uniformity of the emitted laser beams from the LiDAR 1.

In an embodiment, the LiDAR 1 is a combination where multiple lasers 1121 form a laser array corresponding to multiple constant current power adjustable modules 111, each row, column, or block of the laser array can be controlled by an independent constant current power adjustable module 111. This configuration ensures higher accuracy of the emitted laser beams from the LiDAR 1. Different regions of the laser array can emit laser beams with different powers, achieving various detection effects and improving the overall applicability of the LiDAR 1. Additionally, there is no inductor discrepancy issue, ensuring high uniformity of the emitted laser beams from the overall system. Even if the LiDAR 1 includes multiple constant current power adjustable modules 111, the overall heat generated by the circuit is low, and circuit loss is minimized.

In an embodiment, refer to FIG. 13. The constant voltage emission module 112 include an emission control switch (Q8). The source of the emission control switch Q8 is connected to the laser 1121. If the laser 1121 is a laser diode (D3), the source of the emission control switch Q8 is connected to the anode of the laser diode D3, the drain of the emission control switch Q8 is connected to the first end of the energy storage element 1111, and the controlled end of the emission control switch Q8 is connected to receive an emission control signal. The cathode of the laser diode D3 is connected to the second end of the energy storage element 1111. The emission control signal is provided by the controller 12 and can adjust the frequency of the emission control signal according to different needs, thereby adjusting the conduction state and conduction time of the emission control switch Q8.

During the charging stage of the energy storage element 1111, the emission control switch Q8 is turned off. During the discharging stage of the energy storage element 1111, the emission control switch Q8 is turned on, forming a discharging loop through the emission control switch Q8 and the laser 1121, allowing the energy released by the energy storage element 1111 to drive the laser 1121 to emit laser beams. By controlling the conduction state and conduction time of the emission control switch Q8, the reliability of the laser 1121 in different modes can be ensured, ensuring the accuracy and reliability of the emitted laser beams from the constant voltage emission module 112, and thus ensuring the detection accuracy and reliability of the LiDAR 1 that uses the constant voltage emission module 112.

In an embodiment, the laser 1121 can be positioned between the energy storage element 1111 and the ground. In an embodiment, the cathode of the laser 1121 is connected to the second end of the energy storage element 1111, and the anode of the laser 1121 is grounded.

## Claims

1. A constant current emission circuit, wherein the constant current emission circuit comprises:
a constant current power adjustable module, comprising an energy storage element, wherein an input end of the constant current power adjustable module is connected to an emission power supply, so as to receive the output power supply voltage to charge the energy storage element, the constant current power adjustable module provides a constant current to the energy storage element and adjusts an energy stored in the energy storage element; and
a constant voltage emission module, comprising a laser, wherein the laser is connected to the energy storage element, and the laser emits a laser beam when the energy storage element discharges energy, and different energies stored in the energy storage element correspond to different laser emission powers.

2. The constant current emission circuit according to claim 1, wherein the constant current power adjustable module further comprises:
a first control circuit, an end of the first control circuit is connected to the emission power supply, and an other end of the first control circuit is connected to the energy storage element; and
a second control circuit, an end of the second control circuit is connected to a second end of the energy storage element, and an other end of the second control circuit is grounded,
wherein when the energy storage element is charged, the first control circuit and the second control circuit are both turned on and a turn-on time of the first control circuit and the second control circuit is controllable, so that the energy storage element is charged by the emission power supply through the first control circuit and the energy stored in the energy storage element is controlled, and a current flowing through the first control circuit and flowing into the energy storage element is a constant current, and when the energy storage element discharges the energy, at least the first control circuit is turned off.

3. The constant current emission circuit according to claim 2, wherein the first control circuit comprises:
a first high-side switch, wherein a drain of the first high-side switch is connected to the emission power supply, a source of the first high-side switch is connected to a first end of the energy storage element, and a controlled end of the first high-side switch receives a power supply control signal.

4. The constant current emission circuit according to claim 2, wherein the first control circuit comprises:
a first switch, which is connected in series between the emission power supply and the first end of the energy storage element.

5. The constant current emission circuit according to any of claims 2 to 4, wherein the second control circuit comprises:
a first low-side switch, wherein a drain of the first low-side switch is connected to the second end of the energy storage element, and a controlled end of the first low-side switch receives an energy storage control signal; and
a second low-side switch, wherein a drain of the second low-side switch is grounded, a source of the second low-side switch is connected to a source of the first low-side switch, and a controlled end of the second low-side switch receives the energy storage control signal.

6. The constant current emission circuit according to any of claims 2 to 4, wherein the second control circuit comprises:
a first diode, wherein an anode of the first diode is connected to the second end of the energy storage element, and a cathode of the first diode is grounded.

7. The constant current emission circuit according to claim 6, wherein the laser comprises:
a laser diode, wherein an anode of the laser diode is grounded, and a cathode of the laser diode is connected to an anode of the first diode and the second end of the energy storage element.

8. The constant current emission circuit according to any of claims 2 to 4, wherein the second control circuit comprises:
a second switch, which is connected in series between the second end of the energy storage element and a grounding end.

9. The constant current emission circuit according to any of claims 1 to 5, wherein the constant voltage emission module further comprises:
an emission control switch, wherein a source of the emission control switch is connected to the laser, a drain of the emission control switch is connected to the first end of the energy storage element, and a controlled end of the emission control switch receives an emission control signal, and a cathode of the laser is connected to the second end of the energy storage element,
wherein when the energy storage element is charged, the emission control switch is turned off, and when the energy storage element discharges the energy, the emission control switch is turned on.

10. A LiDAR, comprising:
a constant current emission circuit according to any one of claims 1 to 9;
a controller, connected to a constant current power adjustable module and a constant voltage emission module; and
a laser receiving circuit, connected to the controller and receives an echo light formed by a laser beam emitted by the constant current emission circuit.

11. The LiDAR according to claim 9, further comprising:
a laser array, which is composed of M*N lasers, wherein M and N respectively are a number of rows and a number of columns of the lasers in the laser array, M and N are both positive integers, and either M or N is greater than or equal to 2.
